Europäisches Patentamt

European Patent Office

Office européen des brevets

(11) Numéro de publication: **0 084 474**
**B1**

(12) **FASCICULE DE BREVET EUROPEEN**

(45) Date de publication du fascicule du brevet:
**17.04.85**

(21) Numéro de dépôt: **83400036.6**

(22) Date de dépôt: **07.01.83**

(51) Int. Cl.⁴: **H 03 H 19/00**

(54) Filtre passe-haut du premier ordre et application en téléphonie.

(30) Priorité: **15.01.82 FR 8200612**

(43) Date de publication de la demande:
**27.07.83 Bulletin 83/30**

(45) Mention de la délivrance du brevet:
**17.04.85 Bulletin 85/16**

(84) Etats contractants désignés:
**CH DE FR GB IT LI NL**

(56) Documents cités:
**IEEE JOURNAL OF SOLID-STATE CIRCUITS, vol. SC-14, no. 6, décembre 1979, pages 970-980, New York, US, R. GREGORIAN et al. "CMOS switched-capacitor filters for a PCM voice CODEC"**
**IEEE JOURNAL OF SOLID-STATE CIRCUITS, vol. SC-14, no. 6, décembre 1979, pages 961-969, New York, US, Y.A. HAQUE et al.: "A two chip PCM voice CODEC with filters"**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Bertails, Jean-Claude, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

BUNDESDRUCKEREI BERLIN

## Description

La présente invention concerne les filtres et elle va être exposée en référence à une application particulière qui est le traitement de la parole en vue de sa conversion en signaux numériques avant transmission sur une ligne téléphonique. Cette application, très importante, permet de bien comprendre l'intérêt du filtre selon l'invention, mais d'autres applications peuvent bien entendu être envisagées pour ce filtre.

Dans la transmission téléphonique numérique, les signaux à fréquence vocale issus d'un microphone subissent un filtrage pour ne conserver que des signaux dans une bande de fréquence intéressante (200 à 3400 hertz par exemple) avant d'être appliqués à un convertisseur analogique-numérique qui fonctionne de manière échantillonnée à une fréquence qui est par exemple de 8 kHz (largement supérieure aux fréquences vocales transmises). Le convertisseur analogique-numérique examine donc toutes les 125 microsecondes le niveau du signal vocal filtré et le convertit en une valeur numérique binaire transmise vers la ligne téléphonique.

Pour des raisons de facilité d'intégration sur des pastilles semiconductrices de très petites dimensions, on effectue le filtrage essentiellement au moyen de filtres à capacités commutées (selon un principe décrit notamment dans les articles de la revue IEEE Journal of Solid States Circuits, volume SC-12, numéro 6, de décembre 1977, pages 592 à 608). Dans ces filtres, les résistances des circuits sont remplacées par des capacités commutées à une fréquence de commutation supérieure aux fréquences à transmettre à travers le filtre. Par exemple, la fréquence de commutation peut être de 128 kHz.

L'intérêt des filtres à capacités commutées est qu'il permettent de réaliser des fréquences de coupure basses (par exemple un filtre passe-haut coupant à 200 Hz) sans exiger des composants qui occuperaient une surface de silicium trop importante en circuit intégré. Ils permettent notamment, dans l'application envisagée, de placer filtres et codeur analogique-numérique sur le même substrat, et même de réaliser sur le même substrat un circuit de filtrage et codage pour l'émission et un circuit de décodage et filtrage pour la réception (codec + filtre).

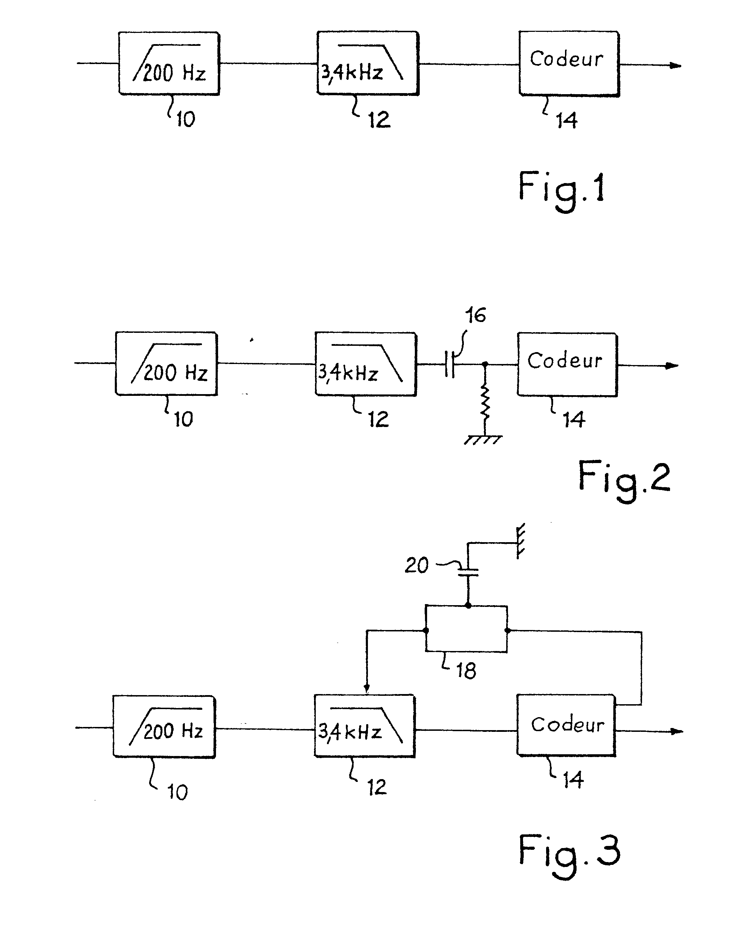

La figure 1 montre un schéma possible de filtrage et codage, avec un premier filtre passe-haut 10, par exemple du troisième ordre, avec une fréquence de coupure de 200 Hz environ, puis un filtre passe-bas 12, par exemple du cinquième ordre avec une fréquence de coupure de 3,4 kHz environ, puis un convertisseur analogique-numérique 14.

Malheureusement, le filtre passe-bas, qui est un filtre actif constitué à partir d'amplificateurs opérationnels, présente à sa sortie une tension de décalage non négligeable (par exemple de l'ordre de 200 millivolts) qui est interprétée par le convertisseur comme un niveau de signal à coder numériquement. Ceci est particulièrement gênant du fait que la loi de codage du convertisseur est établie avec une compression importante destinée à améliorer l'étendue dynamique des signaux transmis. Ainsi, les faibles signaux sont repérés avec des niveaux de codage beaucoup plus rapprochés que les signaux plus forts. Les variations de la tension de décalage en sortie décalent le niveau global des faibles signaux et leur donnent une valeur numérique apparente d'autant plus erronée que la compression dynamique est plus prononcée.

Un moyen pour éliminer le décalage résiduel de sortie dû aux amplificateurs serait d'intercaler un réseau RC avec une capacité 16 en série entre le filtre passe-bas 12 et le codeur 14 (figure 2). Mais, compte tenu des fréquences à transmettre, la capacité 16 doit être trop importante (de l'ordre de 40 nanofarads) pour être intégrée sur le même substrat que le filtre et le codeur. Il faut donc la prévoir à l'extérieur, avec deux bornes d'accès dans le circuit intégré, et on sait qu'il faut diminuer au maximum le nombre de bornes d'accès extérieur d'un circuit intégré.

On a proposé aussi (figure 3) de constituer une boucle d'asservissement agissant sur une source de compensation 18 du décalage résiduel, cette boucle prélevant comme signal d'entrée le bit de signe du convertisseur 14 et agissant sur la source de compensation de manière qu'en moyenne le bit de signe soit aussi souvent à 0 qu'à 1 ; en effet, sur une période de temps moyenne, le signal de parole doit présenter une valeur moyenne nulle. Si on trouve un bit de signe plus souvent à 1 qu'à 0, c'est qu'il y a un décalage résiduel positif à compenser. Mais la boucle d'asservissement ainsi réalisée a une constante de temps non négligeable qui affecte le temps de réponse du codeur. De plus, elle nécessite elle-même une capacité de filtrage 20, avec toutefois une seule borne d'accès extérieur dans le circuit intégré (fig 3).

Pour éviter cette capacité importante et la ou les bornes d'accès extérieur, on propose ici une solution différente en partant de l'idée que le filtre passe-haut, dont on a dit qu'il pouvait être du troisième ordre, est décomposé en un filtre passe-haut en amont, par exemple du deuxième ordre, et un filtre passe-haut du premier ordre qui ne présente aucune tension de décalage résiduel et qui est placé en aval du filtre passe-bas, immédiatement en amont du convertisseur.

Plus précisément, l'invention concerne un filtre échantillonné comportant un élément de filtrage passe-haut du premier ordre, sans tension de décalage d'entrée, qui, ainsi placé devant un codeur, élimine les inconvénients mentionnés ci-dessus, mais qui est utilisable dans bien d'autres applications que celle que l'on vient d'exposer.

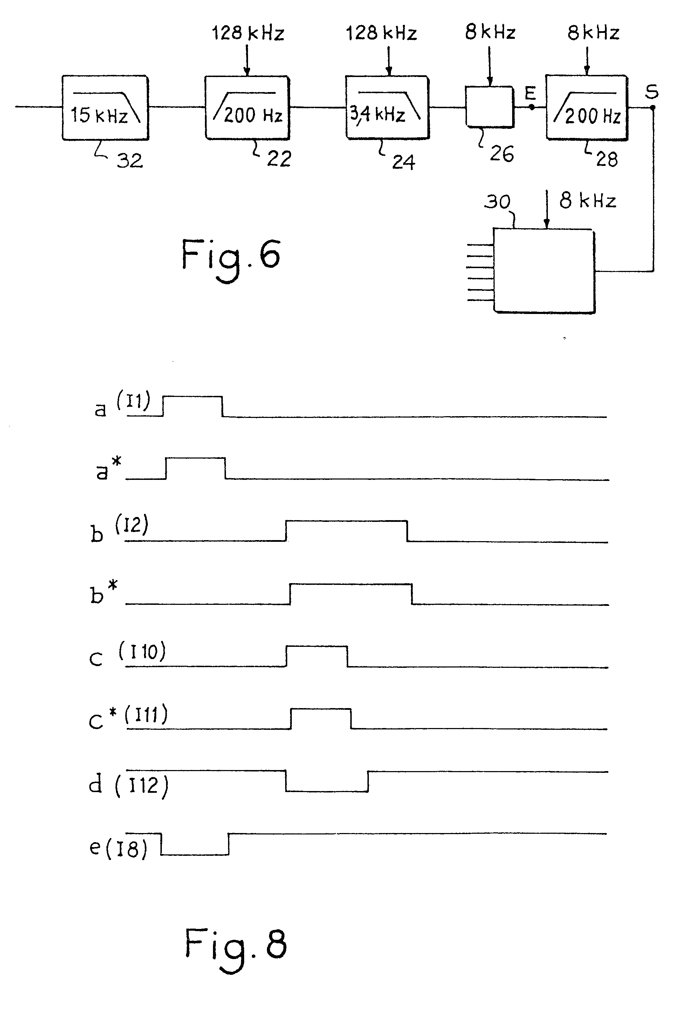

Cet élément de filtrage se distingue d'autres filtres passe-haut existants, tels que ceux qui sont décrits dans l'article de Roubik Gregorian et William Nicholson »CMOS Switched-Capacitor Filters for a PCM Voice CODEC«, IEEE Journal of Solid-State Circuits vol. SC-14 n° 6 décembre 1979, pages 970—980 notamment à la figure 6a, en ce qu'il est du premier ordre et en ce qu'il comporte un moyen d'élimination de la tension de décalage à l'entrée.

L'élément de filtrage passe-haut comprend deux amplificateurs opérationnels ayant chacun une entrée inverseuse, une entrée non inverseuse reliée à un potentiel fixe, et une sortie; lélément de filtrage comporte une entrée reliée à travers une première capacité à l'entrée inverseuse du premier amplificateur et une sortie reliée à la sortie de cet amplificateur; selon l'invention, un premier interrupteur est connecté entre l'entrée inverseuse et la sortie du premier amplificateur et un deuxième interrupteur est connecté entre l'entrée inverseuse et la sortie du second amplificateur; l'entrée inverseuse du premier amplificateur est reliée à une borne d'une deuxième capacité dont l'autre borne est reliée à travers un troisième interrupteur à la sortie du second amplificateur et à travers un quatrième interrupteur à la sortie du premier amplificateur; l'entrée inverseuse du second amplificateur est reliée à une borne d'une troisième capacité et d'une quatrième capacité, l'autre borne de la troisième capacité étant reliée à travers un cinquième et un sixième interrupteur respectivement à la sortie du second et du premier amplificateur, et l'autre borne de la quatrième capacité étant reliée à travers un septième et un huitième interrupteur respectivement à la sortie du second amplificateur et à un potentiel de référence; un circuit de commande de commutation est prévu pour assurer une conduction périodique des divers interrupteurs selon deux phases de conduction disjointes à chaque période, les interrupteurs de numéro impair étant fermés pendant la première phase et les interrupteurs de numéro pair étant fermés pendant la deuxième phase.

Les interrupteurs sont de préférence constitués par des transistors MOS (Metal Oxyde Semiconducteur).

Le filtre pourvu de cet élément de filtrage passe-haut sans tension de décalage d'entrée comprend de préférence, en amont de l'élément de filtrage, un échantillonneur-bloqueur fonctionnant à la même fréquence que les interrupteurs et appliquant à l'entrée de l'élément de filtrage des échantillons de tension prélevés au moment de la deuxième phase d'une période d'échantillonnage et bloqués au moins jusqu'à la fin de la première phase de la période suivante.

Selon une caractéristique particulièrement intéressante de l'invention, le filtre fait partie d'un ensemble de filtrage et conversion analogique-numérique et l'élément de filtrage passe-haut est placé immédiatement en amont d'un convertisseur du type comportant un comparateur à seuil variable sous forme d'un amplificateur, cet amplificateur étant constitué par le second amplificateur opérationnel de l'élément de filtrage passe-haut, qui est utilisé en dehors des première et deuxième phases proprement dites de chaque période d'échantillonnage, à un moment où le second interrupteur est ouvert.

D'autres caractéristiques et avantages de l'invention apparaîtront à la lecture de la description détaillée qui suit et qui est faite en référence aux dessins annexés dans lesquels:

les figures 1 à 3, déjà décrites, représentent l'agencement général d'un codeur précédé de filtres dans la technique antérieure;

la figure 4 représente l'élément de filtrage passe-haut du premier ordre selon l'invention;

la figure 5 représente un diagramme temporel des phases de fermeture des interrupteurs;

la figure 6 représente un schéma-bloc de filtre et codeur analogique-numérique pour la mise en appliation de l'invention;

la figure 7 représente l'échantillonneur-bloqueur, le filtre passe-haut et le convertisseur de la figure 6;

la figure 8 montre un diagramme temporel des signaux de commande de fermeture des divers interrupteurs de la figure 7.

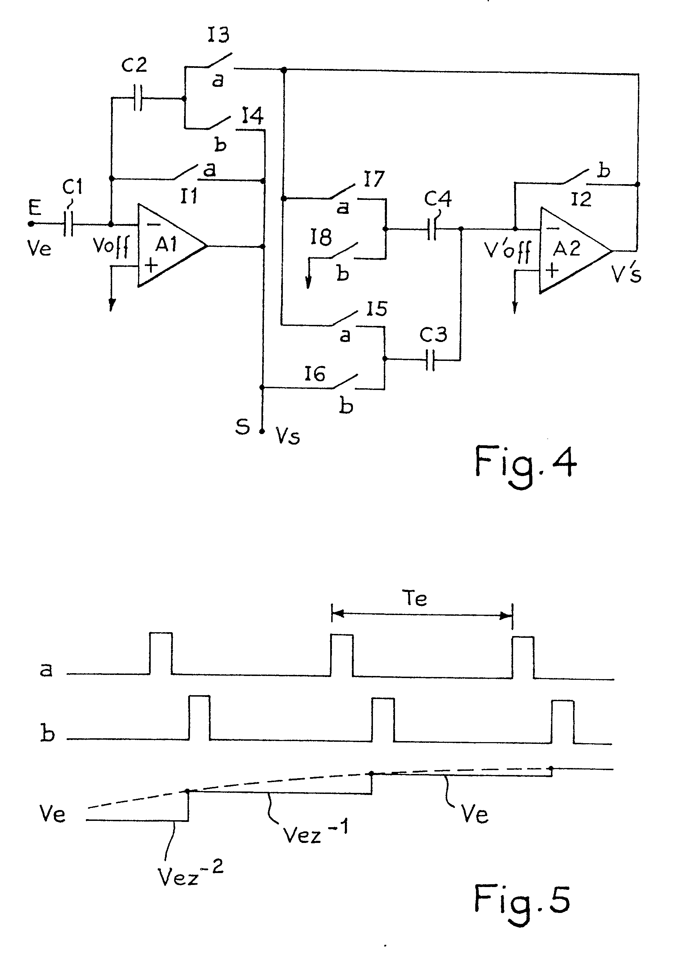

La structure de l'élément de filtrage du premier ordre de la figure 4 a été définie ci-dessus. Les deux amplificateurs sont désignés respectivement par A1 et A2, les quatre capacité par C1, C2, C3, C4 et les huit interrupteurs par I1, I2, I3, I4, I5, I6, I7, I8.

L'entrée E de l'élément de filtrage reçoit une tension Ve qui est échantillonnée et bloquée à une fréquence qui est par exemple de 8 kHz et qui est la même que la fréquence d'actionnement des huit interrupteurs.

La sortie S de l'élément de filtrage est la sortie de l'amplificateur A1.

Les interrupteurs de rang impair I1, I3, I5, I7 sont rendus conducteurs pendant une première phase de chaque période d'échantillonnage Te. Les interrupteurs de rang pair sont rendus conducteurs pendant une deuxième phase disjoints de la première. Ces deux phases sont représentées sur la figure 5, lignes a et b respectivement. Les lettres a et b près des interrupteurs de la figure 4 rappellent les phases de conduction de chaque interrupteur. La troisième ligne de la figure 5 montre comment la tension à filtrer (représentée en pointillés) est échantillonnée au moment de la phase b, avec une période égale à la période Te de fonctionnement des interrupteurs, et comment elle est bloquée à la valeur échantillonnée, au moins jusqu'après la fin de la première phase a de la première période suivante (en pratique jusqu'à la deuxième phase de la période suivante).

Pour montrer quelle est la fonction de transfert de ce filtre et comment les tensions de décalage (offset) des amplificateurs sont éliminées, on raisonnera à partir de transformées en z comme cela est classique pour des systèmes échantillonnées.

En prenant comme référence de temps une période d'échantillonnage donnée Te (indiquée sur la figure 5), et en appelant Vs et Vs' les tensions de sortie utiles en sortie des amplificateurs pendant cette période, c'est à dire en pratique Vs pendant le niveau haut de la phase b et V's pendant le niveau haut de la phase a, on appellera $Vsz^{-1}$ et $V'sz^{-1}$, conformément à la notation en z, les tensions utiles de sortie des amplificateurs aux instants correspondants de la période précédant la période de référence.

De même Ve, $Vez^{-1}$ et $Vez^{-2}$ représenteront les tensions d'entrée à la période de référence, à la période précédente et à la période qui précède encore. Mais, étant donné que Ve est échantillonnée et bloquée à partir de la deuxième phase, on voit que Ve change au milieu de chaque période et qu'on a simultanément pendant la phase a de la période de référence une tension de sortie V's et une tension d'entrée $Vez^{-1}$, puis simultanément pendant la phase b une tension de sortie Vs et une tension d'entrée Ve.

Si enfin on apelle Voff et V'off les tensions de décalage à l'entrée des amplificateurs A1 et A2 respectivement, ces tensions étant supposées quasiment invariables d'une période à la suivante puisqu'il s'agit de tensions à dérive très lente, on peut définir le fonctionnement du filtre de la manière suivante:

A la phase b de la période précédant la période de référence, le deuxième amplificateur A2 est bouclé en gain unitaire par l'interrupteur I2 et on applique des potentiels $Vsz^{-1}$ et zéro respectivement sur les capacités C3 et C4 qui se chargent ou se déchargent en conséquence.

Le potentiel de référence relié à l'interrupteur I8 est par exemple un potentiel zéro auquel sont reliées les entrées non inverseuses des amplificateurs.

Compte-tenu de la tension d'offset V'off présente à l'entrée de l'amplificateur A2, la somme des charges des capacités C3 et C4 est $(Vsz^{-1}-V'off)C3-V'offC4$.

A la fin de la phase b l'interrupteur I2 s'ouvre et cette charge globale est piégée; les interrupteurs I4, I6, I8 sont ouverts également à la fin de la phase b mais avec un léger retard par rapport à l'interrupteur I2.

Quand la phase a de la période suivante commence, les interrupteurs I1, I3, I5, I7 sont fermés de sorte que:

1. le potentiel V's est appliqué simultanément à C3 et C4; ce potentiel a priori indéterminé s'ajuste automatiquement en fonction de la charge piégée sur C3 et C4, de sorte que soit respectée la conservation des charges: V's doit être tel que:

$$(V's-V'off)(C3+C4) = (Vsz^{-1}-V'off)C3-V'offC4$$
ou
$$V's = Vsz^{-1}C3/(C3+C4) \tag{1}$$

2. V's est appliqué à travers l'interrupteur I3 à C2 pendant que le premier amplificateur A1 est bouclé en gain unitaire par l'interrupteur I1 et alors que $Vez^{-1}$ est appliqué sur C1; il en résulte qu'une charge $C1(Vez^{-1}-Voff)$ apparaît sur la capacité C1 et une charge $C2(V's-Voff)$ sur la capacité C2.

La somme de ces charges sur C1 et C2 est piégée à la fin de la phase a, au moment de l'ouverture de l'interrupteur I1. Les interrupteurs I3, I5 et I7 sont ouverts à la fin de la phase a, très légèrement après l'interrupteur I1.

La charge totale piégée est $(Vez^{-1}-Voff)C1+(V's-Voff)C2$.

A la phase b suivante, les interrupteurs I2, I4, I6, I8 sont fermés de sorte que le potentiel Vs est appliqué à la capacité C2. Mais la tension d'entrée Ve change à ce moment (échantillonnage sur la deuxième phase) et passe de $Vez^{-1}$ à Ve.

Il en résulte que la tension de sortie de l'amplificateur A1 s'ajuste automatiquement pour respecter la conservation des charges piégées: Vs doit prendre une valeur telle que:

$$(Vs-Voff)C2+(Ve-Voff)C1 = (Vez^{-1}-Voff)C1+(V's-Voff)C2$$
ou
$$VsC2+VeC1 = Vez^{-1}C1+V'sC2 \tag{2}$$

En réalité il faudrait considérer des tensions Voff et $Voffz^{-1}$ ou V'off et $V'offz^{-1}$ mais on considère que $Voff = Voffz^{-1}$ et $V'off = V'offz^{-1}$ compte tenu de la dérive très lente de ces tensions par rapport à la vitesse d'échantillonnage.

En rapprochant les équations (1) et (2) on obtient une fonction de transfert indépendante des deux tensions d'offset, qui est:

$$\frac{Vs}{Ve} = -\frac{C1}{C2}\frac{z-1}{z-C3/(C3+C4)}$$

4

Il s'agit bien d'une fonction de transfert en z d'un filtre passe-haut du premier ordre.

Bien entendu la tension Vs doit être »lue« en sortie de l'élément de filtrage pendant la phase b.

Un des avantages très importants de cette structure particulière de filtre, outre l'élimination de l'effet des tensions de décalage, est la possibilité d'obtenir précisément la fréquence de coupure désirée malgré la dispersion de fabrication des capacités dans les circuits intégrés. Cette fréquence de coupure dépend du rapport C3/(C3 + C4), et, dans les applications où elle est relativement basse (application en téléphonie par exemple), le rapport C3/(C3 + C4) est assez voisin de 1.

Physiquement, on comprend que le fait d'appliquer d'abord Vs sur une capacité puis V's sur une capacité de valeur différente fait intervenir directement le rapport de ces deux capacités. Mais ici on applique d'abord Vs sur la capacité C3 puis V's sur la même capacité C3 plus une petite capacité C4. Seule intervient comme imprécision la dispersion de fabrication sur le terme correctif C4/C3 qui est petit devant l'unité.

Les interrupteurs sont de préférence des transistors MOS, et il est particulièrement souhaitable que les interrupteurs I1 et I2 soient des transistors MOS à très faible capacité parasite. Le circuit de commande de ces interrupteurs n'est pas représenté.

Pour revenir à l'application particulièrement intéressante du filtrage et de la conversion numérique des signaux vocaux en téléphonie, on a représenté à la figure 6 la structure de circuit qu'on propose de réaliser en utilisant l'élément de filtrage passe-haut selon l'invention.

Le filtrage dans la bande de fréquences utile est effectué par exemple par un filtre passe-haut 22 à capacités commutées, du second ordre, échantillonné à 128 kHz, de fréquence de coupure d'environ 200 Hz, suivi d'un filtre passe-bas 24 à capacités commutées, du cinquième ordre, échantillonné à 128 kHz, de fréquence de coupure d'environ 3,4 kHz, puis par un échantillonneur-bloqueur 26 qui travaille à 8 kHz, puis par un filtre passe-haut du premier ordre 28, sans offset, conforme à l'invention, de fréquence de coupure environ 200 Hz, qui travaille à la même fréquence (8 kHz) que l'échantillonneur-bloqueur 26 et dont les phases de commutation sont synchronisées avec celles de l'échantillonneur-bloqueur de la manière expliquée en référence aux figures 4 et 5. Un filtre 32 dit »antirepliement«, non échantillonné, est placé en amont du filtre 22; il s'agit d'un filtre passe-bas de fréquence de coupure environ 15 kHz (de préférence une cellule dite de Sallen and Key), qui élimine notamment les fréquences dans la bande 124 kHz à 132 kHz (centrée sur la fréquence d'échantillonnage).

La sortie du filtre passe-haut 28 est reliée à un convertisseur analogique-numérique 30 qui travaille également de manière échantillonnée, à la même fréquence de 8 kHz que le filtre 28, pour fournir toutes les 125 microsecondes un nombre binaire représentant l'amplitude d'un échantillon de signal appliqué à son entrée. La fonctionnement du convertisseur est synchronisé avec celui des interrupteurs I1 à I8 du filtre 28 de manière que les échantillons de signal Vs appliqués au convertisseur pour être convertis soient des échantillons prélevés sur la sortie S du filtre 28 à la phase b de la période d'échantillonnage Te.

Le convertisseur 30 comporte au moins un comparateur pour comparer la tension Vs à des valeurs de référence en vue de définir un nombre binaire représentatif du niveau de Vs. Selon une caractéristique importante de l'invention, ce comparateur est incorporé au filtre 28 et est constitué essentiellement par le second amplificateur A2 qui fonctionne périodiquement comme comparateur en dehors des phases a et b. La tension à comparer à des valeurs de référence est définie par la charge piégée sur la capacité C3 après la fin de la phase b.

Cette charge doit être équilibrée par un potentiel convenable sur la capacité C3 ou sur une autre capacité reliée à l'entrée de l'amplificateur A2, ou mieux encore sur une fraction de la capacité C3 si celle-ci est composée de plusieurs capacités en parallèle, pour que la sortie de l'amplificateur reste à zéro. Un déséquilibre dans un sens ou dans l'autre fait basculer la sortie de l'amplificateur A2 qui est en boucle ouverte. On se sert du sens de basculement pour définir une modification des potentiels, ou des capacités d'entrée sur lesquelles on applique ces potentiels, pour se rapprocher par approximations successives d'un état d'équilibre.

Un circuit logique de recherche effectue automatiquement cette approche à chaque période d'échantillonnage, après la fin de la deuxième phase b.

On va décrire un exemple de mise en oeuvre particulièrement intéressant, dans lequel la capacité C3 est décomposée en une pluralité de capacités en parallèle pouvant être mises en service individuellement par des interrupteurs respectifs; ces capacités, lorsqu'elles sont effectivement réunies en parallèle, jouent le rôle de la capacité C3 dans le filtre de la figure 3; lorsqu'elles sont prises individuellement, elles permettent en quelque sorte d'établir un potentiel variable servant de référence au convertisseur lors de la recherche par approximation successives.

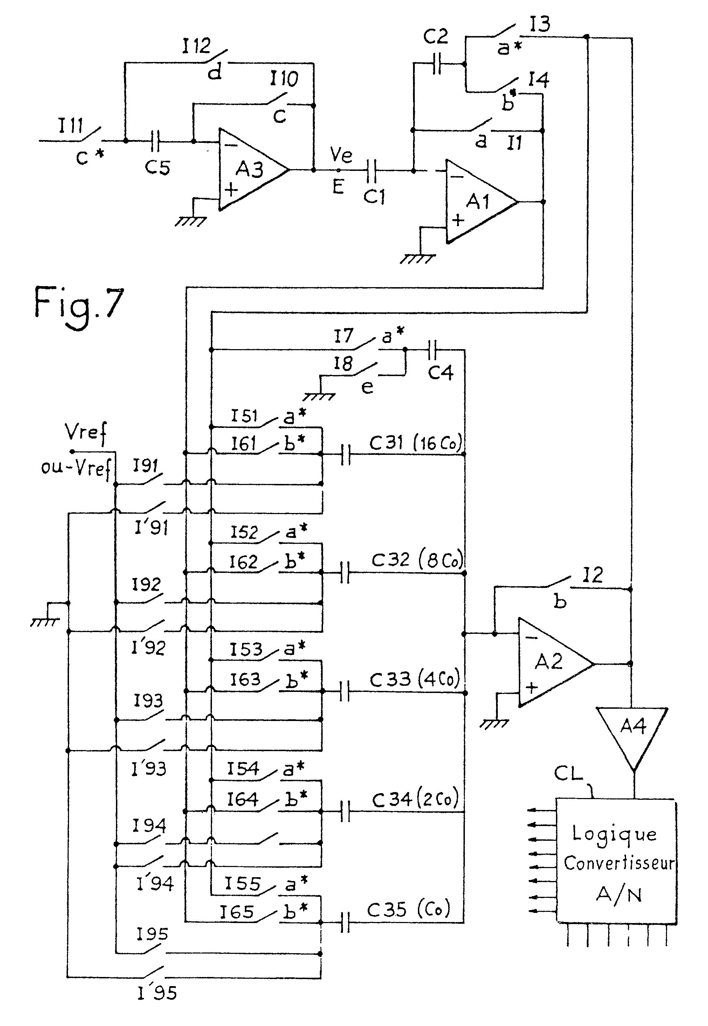

Un schéma de ce filtre passe-haut du premier ordre associé à un convertisseur analogique-numérique et précédé par un échantillonneur-bloqueur est représenté à la figure 7.

L'échantillonneur-bloqueur (à 8 kHz) comprend un amplificateur opérationnel A3 ayant une entrée non-inverseuse à la masse, une entrée inverseuse reliée à une borne d'une capacité C5, et une sortie reliée d'une part à l'entrée inverseuse par un interrupteur I10 et d'autre part à l'autre borne de la capacité C5 par un interrupteur I12. Cette autre borne est reliée par un interrupteur I11 à une entrée de signal qui reçoit le signal à échantillonner et bloquer (signal issu en fait du filtre passe-bas 24 dans la chaîne de la figure 6).

Comme le filtre passe-bas 24 est lui-même échantillonné, il faut noter que la phase de conduction de l'interrupteur I11 est synchronisée avec cet échantillonnage (à 128 kHz) pour que la tension d'entrée n'oscille pas pendant la fermeture de l'interrupteur I11.

La sortie de l'échantillonneur-bloquer, c'est à dire la sortie de l'amplificateur A3, est reliée à l'entrée E du filtre passe-haut du premier ordre qui est ici encore constitué par un schéma à deux amplificateurs opérationnels A1 et A2 correspondant au schéma de la figure 4, avec cette différence que la capacité C3 est remplacée par plusieurs capacités partielles (C31, C32, C33, C34 et C35 sur la figure 7), et que les interrupteurs I5 et I6 sont chacun remplacés par autant d'interrupteurs (I51, I52, I53, I54, I55 et I61, I62, I63, I64, I65) qu'il y a de capacités partielles.

Les interrupteurs I51 à I55 sont tous commandés ensemble (en même temps que l'interrupteur I3); les interrupteurs I61 à I65 sont également tous commandés ensemble (en même temps que l'interrupteur I4) de sorte que le fonctionnement du circuit est le même que si on avait une capacité unique C3 égale à la somme des capacités partielles.

$$C3 = C31 + C32 + C33 + C34 + C35$$

Une autre différence avec le schéma de la figure 4, liée à cette décomposition de la capacité C3 en capacités partielles isolées les unes des autres par leurs deux interrupteurs respectifs, est le fait qu'on peut appliquer un potentiel de référence ou un potentiel zéro individuellement sur chacune des capacités partielles (ou sur plusieurs à la fois), par des interrupteurs respectifs I91 et I'91 pour C31, I92 et I'92 pour C32, I93 et I'93 pour C33, I94 et I'94 pour C34 et I95 et I'95 pour C35. Ce potentiel peut prendre lui-même plusieurs valeurs, par exemple une tension de référence Vréf et son inverse −Vréf.

Enfin, le filtre associé à un convertisseur analogique-numérique de la figure 7 comprend éventuellement un amplificateur supplémentaire A4 en sortie de l'amplificateur A2 pour le cas où ce dernier n'aurait pas un gain suffisant pour basculer nettement pour le plus petit échelon de tension à détecter.

La sortie de l'amplificateur A4 (sortie en tout ou rien) est appliquée à un circuit logique de recherche d'équilibre CL qui a pour fonction (comme c'est d'ailleurs le cas dans tout convertiseur analogique-numérique) d'effectuer, selon un programme d'exploration préétabli, une comparaison de la tension à convertir successivement à diverses valeurs de référence repérées selon un code numérique, jusqu'à trouver la valeur de référence la plus proche de la tension à convertir, et qui a pour fonction de fournir à sa sortie un code numérique correspondant à cette valeur.

Ici, on profite du fait qu'à la fin de la phase b, la tension Vs de sortie du filtre (sortie S de l'amplificateur A1) est stockée sur le condensateur C3. Si on maintient ensuite à zéro la tension aux bornes de C4 (en laissant fermé l'interrupteur I8), on voit que la charge stockée sur C3 est VsC3.

Si alors on applique une tension V à une des capacités C31 à C35, par exemple la capacité C31, en appliquant un potentiel zéro aux autres, la sortie de l'amplificateur A2 (qui est en boucle ouverte) basculera dans un sens ou dans l'autre selon que V est plus grand ou moins grand que VsC3/C31.

Les capacités partielles C31 à C35 ont des valeurs pondérées, de préférence en progression géométrique de raison 2; par exemple C35 = Co, C34 = 2 Co, C33 = 4 Co, C32 = 8 Co et C31 = 16 Co.

La recherche d'équilibre pour effectuer la conversion s'effectue de la manière suivante (pendant que les interrupteurs I1, I2, I51 à I55 et I61 à I65 sont ouverts):

Le circuit logique CL applique une tension zéro sur toutes les capacités partielles à la fois (fermeture des interrupteurs I'91 à I'95). Selon le sens de basculement de l'amplificateur A2 on détermine le bit de signe de la conversion de Vs. Ce bit de signe détermine, pour tout le programme de recherche qui suit, le signe de la tension de référence appliquée ensuite aux capacités partielles (Vréf ou −Vréf).

La phase suivante consiste à appliquer Vréf (par exemple) à C31 seulement en ouvrant l'interrupteur I'91 et en fermant l'interrupteur I91. Selon le sens du basculement de l'amplificateur A2, le circuit logique CL rouvre ou laisse fermé l'interrupteur I91.

On ouvre alors l'interrupteurs I'92 et on ferme l'interrupteur I92 pour appliquer Vréf à travers C32. Selon le sens du basculement de l'amplificateur, le circuit logique rouvre ou laisse fermé l'interrupteur I92, et ainsi de suite jusqu'à la plus petite capacité C35, selon un processus d'approximations successives.

L'état des interrupteurs I91 à I95 ou I'91 à I'95 constitue alors un code numérique binaire de la valeur de la tension Vs, ce code étant fourni par le circuit CL qui commande la fermeture des interrupteurs.

Le processus peut d'ailleurs se poursuivre par une phase de mesure plus précise en appliquant par exemple alors successivement des valeurs de Vréf différentes jusqu'à obtenir une approximation plus précise de Vs.

Bien entendu, ce processus s'effectue entièrement pendant une période d'échantillonnage Te (125 microsecondes), le circuit logique CL travaillant à une fréquence nettement plus élevée pour permettre l'exécution de toute la recherche pendant cette période.

On va maintenant rappeler, en référence à la figure 8, les phases de fermeture des divers interrupteurs I1 à I11 de la figure 7, à l'exception des interrupteurs I91 à I95 et I'91 à I'95 qui sont actionnés seulement par le circuit logique de recherche, pour bien montrer comment la phase de conversion analogique-numérique peut s'effectuer avec le même amplificateur A2 qui sert au filtrage passe-haut, sans perturber le fonctionnement expliqué à propos des figures 4 et 5. Il est à noter que l'actionnement des interrupteurs autres que I91 à I95 et I'91 à I'95 est effectué à la fréquence de 8 kHz par le circuit de commande de commutation non représenté, déjà mentionné à propos des figures 4 et 5. Le circuit logique de recherche CL est synchronisé sur ce circuit de commande de commutation afin que la recherche s'effectue complètement en dehors de la phase b de conduction de l'interrupteur I1.

La phase de fermeture de l'interrupteur I1 au début d'une période d'échantillonnage et de conversion de 125 microsecondes est un créneau d'une durée de 5 à 10 microsecondes.

Un créneau légèrement décalé, par exemple par deux inverseurs en cascade, constitue une phase a*, l'astérisque indiquant le léger retard nécessaire entre l'ouverture de l'interrupteur I1 et l'ouverture des interrupteurs I3, I5 et I7. Ici, l'interrupteur I5 est remplacé par les interrupteurs I51 à I55, tous commandés en même temps que I3 et I7 par la phase a*.

L'interrupteur I2 est fermé pendant une phase b disjointe de la phase a (et même de a*). Les interrupteurs I4 et I61 à I65 sont fermés pendant un créneau b* qui est légèrement retardé par rapport au créneau de la phase b. L'interrupteur I8, dont on a expliqué qu'il devait être fermé pendant la phase b* pour le fonctionnement du filtre, est ici fermé pendant la phase b* pour le fonctionnement du filtre, est ici fermé non seulement pendant la durée de la phase b* (pour le filtrage) mais pendant toute la durée nécessaire à la phase de conversion analogique numérique. En fait, il est ouvert seulement au moment des phases a et a*. Une phase e de conduction de l'interrupteur I8 a été représentée en figure 8: elle comprend un long créneau commençant après la phase a* et se terminant au début de la phase a de la période suivante.

Enfin, l'échantillonneur-bloqueur est synchronisé sur la phase b du cycle de la manière suivante: une phase c de conduction de l'interrupteur I10 démarre en même temps que la phase b mais est plus courte. Une phase c* de conduction de l'interrupteur I11 correspond à la phase c mais se termine légèrement après. Une phase d de conduction de l'interrupteur I12 débute après la fin de la phase c* mais pendant que la phase b est encore en cours (échantillonnage pendant la phase b); elle dure jusqu'à la phase b de la période suivante (en tout cas jusqu'après la phase a) pour que l'échantillon bloqué soit toujours présent à l'entrée E à la phase a de la période suivante.

## Revendications

1. Filtre échantillonné, comprenant un élément de filtrage passe-haut du premier ordre comportant deux amplificateurs opérationnels (A1 et A2) ayant chacun une entrée inverseuse, une entrée non inverseuse reliée à un potentiel fixe et une sortie, l'élément de filtrage comportant une entrée (E) reliée à travers une première capacité (C1) à l'entrée inverseuse du premier amplificateur (A1) et une sortie (S) reliée à la sortie de cet amplificateur, caractérisé en ce qu'il comporte en outre un premier interrupteur (I1) connecté entre l'entrée inverseuse et la sortie du premier amplificateur, un deuxième interrupteur (I2) connecté entre l'entrée inverseuse et la sortie du deuxième amplificateur, l'entrée inverseuse du premier amplificateur étant reliée à une borne d'une deuxième capacité (C2) dont l'autre borne est reliée à travers un troisième interrupteur (I3) à la sortie du second amplificateur et à travers un quatrième interrupteur (I4) à la sortie du premier amplificateur, l'entrée inverseuse du second amplificateur étant reliée à une borne d'une troisième capacité (C3) et d'une quatrième capacité (C4), l'autre borne de la troisième capacité étant reliée à travers un cinquième et un sixième interrupteur (I5 et I6) respectivement à la sortie du second et du premier amplificateur et l'autre borne de la quatrième capacité étant reliée à travers un septième et un huitième interrupteurs (I7 et I8) respectivement à la sortie du second amplificateur et à un potentiel de référence, un circuit de commande de commutation étant prévu pour assurer une conduction périodique des divers interrupteurs selon deux phases disjointes à chaque période, les interrupteurs de numéro impair étant fermés pendant la première phase et les interrupteurs de numéro pair pendant la deuxième phase.

2. Filtre selon la revendication 1, caractérisé par le fait qu'il comprend en amont de l'entrée de l'élément de filtrage passe-haut du premier ordre, un échantillonneur-bloqueur fonctionnant à la même fréquence que l'échantillonnage du filtre et appliquant des échantillons de tension prélevés au moment de la deuxième phase et bloqués au moins jusqu'à la fin de la première phase de la période d'échantillonnage suivante.

3. Filtre selon l'une des revendications 1 et 2, caractérisé par le fait qu'il fait partie d'un ensemble de filtrage et conversion analogique-numérique, l'élément de filtrage passe-haut du premier ordre (28) étant connecté immédiatement en amont d'un convertisseur (30) du type comportant un comparateur sous forme d'un amplificateur, cet amplificateur étant ledit second amplificateur utilisé en dehors des première et seconde phases à un moment où le second interrupteur est ouvert.

4. Filtre associé à un convertisseur analogique numérique, selon la revendication 3, caractérisé par le fait que le convertisseur comprend un circuit logique de recherche d'équilibre apte à appliquer à l'entrée du deuxième amplificateur (A2), par l'intermédiaire de capacités, des potentiels choisis en fonction du sens de basculement de la sortie du comparateur.

5. Filtre associé à un convertisseur analogique numérique selon la revendication 4, caractérisé par le fait que la troisième capacité (C3) est décomposée en une pluralité de capacités toutes réunies d'un côté à l'entrée inverseuse de l'amplificateur (A2) et susceptibles d'être reliées individuellement par

**0 084 474**

des interrupteurs respectifs soit à la masse, soit à un potentiel de référence de conversion analogique numérique, soit encore à la sortie du premier amplificateur, soit enfin à la sortie du second amplificateur, sous la commande du circuit de commande de commutation et du circuit de recherche d'équilibre.

6. Filtre associé à une conversion analogique numérique selon la revendication 5, caractérisé par le fait que les capacités ont des valeurs respectives choisies selon une progression géométrique de raison 2.

**Patentansprüche**

1. Getastetes Filter, welches ein Hochpaß-Filterelement erster Ordnung enthält, das zwei Operationsverstärker (A1 und A2) enthält, die jeweils einen invertierenden Eingang und einen nicht invertierenden Eingang aufweisen, der mit festem Potential verbunden ist, sowie einen Ausgang besitzen, wobei das Filterelement einen Eingang (E) aufweist, der über eine erste Kapazität (C1) mit dem invertierenden Eingang des ersten Verstärkers (A1) verbunden ist, und einen mit dem Ausgang dieses Verstärkers verbundenen Ausgang (S) besitzt, dadurch gekennzeichnet, daß es ferner einen ersten Unterbrecher (I1), der zwischen den invertierenden Eingang und den Ausgang des ersten Verstärkers geschaltet ist, und einen zweiten Unterbrecher (I2) umfaßt, der zwischen den invertierenden Eingang und den Ausgang des zweiten Verstärkers geschaltet ist, wobei der invertierende Eingang des ersten Verstärkers mit einem Anschluß einer zweiten Kapazität (C2) verbunden ist, deren anderer Anschluß über einen dritten Unterbrecher (I3) mit dem Ausgang des zweiten Verstärkers sowie über einen vierten Unterbrecher (I4) mit dem Ausgang des ersten Verstärkers verbunden ist, wobei der invertierende Eingang des zweiten Verstärkers mit einem Anschluß einer dritten Kapazität (C3) und einer vierten Kapazität (C4) verbunden ist, während der andere Anschluß der dritten Kapazität über einen fünften und über einen sechsten Unterbrecher (I5 und I6) mit dem Ausgang des zweiten bzw. ersten Verstärkers verbunden ist, während der andere Anschluß der vierten Kapazität über einen siebten und über einen achten Unterbrecher (I7 und I8) mit dem Ausgang des zweiten Verstärkers bzw. mit einem Bezugspotential verbunden ist, wobei eine Schaltsteuerschaltung vorgesehen ist, um das periodische Durchschalten der verschiedenen Unterbrecher gemäß zwei voneinander getrennten Phasen in jeder Periode zu gewährleisten, und wobei die Unterbrecher ungerader Zahl während der ersten Phase geschlossen und die Unterbrecher gerader Zahl während der zweiten Phase geschlossen sind.

2. Filter nach Anspruch 1, dadurch gekennzeichnet, daß es vor dem Eingang des Hochpaß-Filterelementes erster Ordnung eine Abtast- und Halteschaltung umfaßt, die mit derselben Frequenz wie die Tastung des Filters arbeitet und Spannungs-Abtastproben anlegt, die im Moment der zweiten Phase abgegriffen und wenigstens bis zum Ende der ersten Phase der darauffolgenden Abtastperiode gespeichert bleiben.

3. Filter nach Anspruch 1 oder 2, dadurch gekennzeichnet, daß es Bestandteil einer Filter- und Analog/Digital-Umsetzeinheit ist, wobei das Hochpaß-Filterelement erster Ordnung (28) unmittelbar vor einen Umsetzer (30) geschaltet ist, welcher einen Komparator in Form eines Verstärkers enthält, wobei dieser Verstärker der genannte zweite Verstärker ist, der außerhalb der ersten und der zweiten Phase zu einem Zeitpunkt benutzt wird, wo der zweite Unterbrecher offen ist.

4. Filter, das einem Analog/Digital-Umsetzer zugeordnet ist, nach Anspruch 3, dadurch gekennzeichnet, daß der Umsetzer eine Logikschaltung zum Aufsuchen des Gleichgewichtes umfaßt, die geeignet ist, um an den Eingang des zweiten Verstärkers (A2) über Kapazitäten Potentiale anzulegen, die in Abhängigkeit vom Kippsinn des Ausganges des Komperators gewählt sind.

5. Filter, das einem Analog/Digital-Umsetzer nach Anspruch 4 zugeordnet ist, dadurch gekennzeichnet, daß die dritte Kapazität (C3) unterteilt ist in eine Mehrzahl von Kapazitäten, die alle auf einer Seite mit dem invertierenden Eingang des Verstärkers (A2) verbunden sind und einzeln über zugehörigen Unterbrecher entweder mit Masse oder mit einem Bezugspotential für die Analog/Digital-Umsetzung verbunden werden können, oder aber mit dem Ausgang des ersten Verstärkers, oder schließlich mit dem Ausgang des zweiten Verstärkers, und zwar unter Steuerung durch die Schaltsteuerschaltung und die Schaltung zum Aufsuchen des Gleichgewichts.

6. Filter, welches einem Analog/Digital-Umsetzer nach Anspruch 5 zugeordnet ist, dadurch gekennzeichnet, daß die Kapazitäten jeweils Werte aufweisen, die gemäß einer geometrischen Progression des Faktors 2 gewählt sind.

**Claims**

1. Sampled filter comprising a high-pass filter element of the first order comprising two operational amplifiers (A1 and A2) each having an inverting input and a non-inverting input connected to a fixed potential and an output, the filter element comprising an input (E) connected through a first capacitor (C1) to the inverting input of the first amplifier (A1) and an output (S) connected to the output of this amplifier, characterized in that it further comprises a first interrupteur (I1) connected between the

8

inverting input and the output of the first amplifier and a second interrupter (I2) connected between the inverting input and the output of the second amplifier, the inverting input of the first amplifier being connected to a terminal of a second capacitor (C2) the other terminal of which is connected through a third interrupter (I3) to the output of the second amplifier and through a fourth interrupter (I4) to the output of the first amplifier, the inverting input of the second amplifier being connected to a terminal of a third capacitor (C3) and a fourth capacitor (C4), the other terminal of the third capacitor being connected through a fifth and a sixth interrupter (I5 and I6) to the output of the second and of the first amplifiers, respectively, and the other terminal of the fourth capacitor being connected through a seventh and an eighth interrupter (I7 and I8) to the output of the second amplifier and to a reference potential, respectively, a switching control circuit being provided to assure a periodic conduction of the different interrupters in accordance with two distinct phases in each period, the interrupters of odd number being closed during the first phase and the interrupters of pair numbers during the second phase.

2. Filter according to claim 1, characterized by the fact that it comprises upstream from the input of the high-pass filter element of first order a sample-and-hold circuit operating at the same frequency as the sampling of the filter and applying voltage samples derived at the moment of the second phase and stored at least until the end of the first phase of the following sampling period.

3. Filter according to any of claims 1 and 2, characterized by the fact that it forms part of a filter and analog/digital conversion unit, the high-pass filter element of first order (28) being directly connected upstream of a converter (30) of the type comprising a comparator in the form of an amplifier, this amplifier being said second amplifier used outside the first and second phases at a moment where the second interrupter is open.

4. Filter associated with an analog/digital converter, according to claim 3, characterized by the fact that the converter comprises a logic balance searching circuit adapted to apply to the input of the second amplifier (A2) and through capacitors, potentials selected as a function of the switching sense of the output of the comparator.

5. Filter associated with an analog/digital converter according to claim 4, characterized by the fact that the third capacitor (C3) is divided into a plurality of capacitors all of which are connected on one side to the inverting input of the amplifier (A2) and susceptible to be individually connected through respective interrupters either to ground or to a reference potential of the analog/digital conversion, or the output of the first amplifier, or finally to the output of the second amplifier, under control of the switching control circuit and of the balance searching circuit.

6. Filter associated with an analog/digital conversion according to claim 5, characterized by the fact that the capacitors have respective values selected in accordance with a geometric progression of the factor 2.

Fig.1

Fig.2

Fig.3

Fig. 4

Fig. 5

Fig.6

Fig.8

Fig.7